# EUROPEAN PATENT SPECIFICATION

(11) **EP 0 482 288 B1**
(45) Date of publication and mention of the grant of the patent: **20.08.1997**
(21) Application number: 91107121.5
(22) Date of filing: 02.05.1991
(51) Int. Cl.: H03G 3/00, H03H 7/25

(54) **Electronic volume controller**
Elektronische Verstärkungsregelung
Circuit de contrôle de gain électronique

(30) Priority: 25.10.1990 JP 287988/90
(43) Date of publication of application: 29.04.1992
(73) Proprietor: PIONEER ELECTRONIC CORPORATION, Meguro-ku Tokyo (JP)
(72) Inventor: Terada, Toyohiko, c/o Kawagoe Koujou, Ooaza Yamada, Kawagoe-shi, Saitama-ken (JP); Sasaki, Yoshio, c/o Kawagoe Koujou, Ooaza Yamada, Kawagoe-shi, Saitama-ken (JP)
(74) Representative: Bohnenberger, Johannes, Dr.

(56) References cited:
- DE-A- 2 048 202
- US-A- 3 858 128
- US-A- 4 683 386
- US-A- 4 831 650

## Description

The present invention relates to an electronic volume controller, and more particularly to a circuit for electronically controlling volume of an acoustic system.

The volume controller has a ladder attenuator comprising a plurality of resistors connected in series, and a plurality of switches corresponding to the resistors. The resistors are connectable to an output one by one with the closing of corresponding switches, thereby decreasing the volume of a reproduced sound. The number of the resistors is determined in accordance with maximum attenuation and the amount of attenuation at each step. Namely, in order to attenuate the input signal thereto from 80dB to 0dB by 1dB per step, eighty resistors and eighty one switches are required.

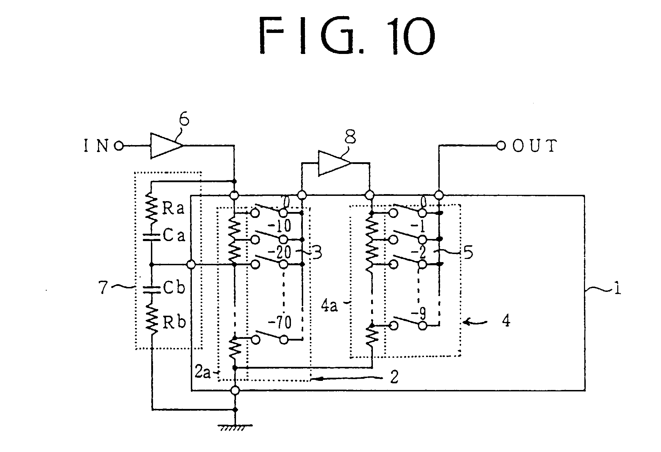

Fig. 10 shows an example of a conventional electronic volume controller 1. The input terminal of the volume controller is connected to a ladder attenuator 2 through a buffer amplifier 6. The ladder attenuator 2 comprises a series of resistors 2a each of which is connected to a corresponding analog switch 3 so that the resistance of the ladder attenuator 2 is changed from 0dB to 70dB by 10dB per step.

The volume controller 1 further has a ladder attenuator 4 which is parallely connected to the ladder attenuator 2 through a buffer amplifier 8. Each resistor 4a of the ladder attenuator 4 is connected to a corresponding analog switch 5 to attenuate the volume from 0dB to 9dB by 1dB per step, thereby finely changing the volume.

A loudness circuit 7 comprising resistors Ra and Rb and capacitors Ca and Cb is connected to both ends of the ladder attenuator 2. A loudness tap of the loudness circuit 7 is connected to one of the analog switches 3 which corresponds to the switch for -20dB.

The switches 5 are selectively closed from 0dB, thereby increasing the attenuation from 0 to -9dB.

For example, when obtaining the attenuation of -22dB, switch 3 corresponding to -20dB and the switch 5 corresponding to -2dB are closed.

The ladder attenuator 2 connected to the loudness circuit 7 is constructed to increase the attenuation by 10dB. Therefore, when only the ladder attenuator 2 is operated, the volume is largely increased at each step, which gives unpleasant feeling to a listener.

Other examples of prior art are disclosed in US-A-4 683 386, in DE-A-2 048 202 and in US-A-4 831 650.

The object of the present invention as it is defined in the appended claim is to provide an electronic volume controller where the resistance at each step is reduced so as to smoothly change the volume.

According to the present invention, there is provided an electronic volume controller comprising, a main ladder attenuator having a series of resistors and switches each of which is provided for connecting a corresponding resistor to an output, and an auxiliary ladder attenuator connected to the main ladder attenuator in series and having a series of resistors and switches each of which is provided for connecting a corresponding resistor to the output, and each of the resistors being provided for interpolating between the adjacent resistors of the main ladder attenuator.

In an aspect of the invention, the resistors of the main ladder attenuator are divided into a first group having a predetermined small resistance interval between adjacent resistors, and a second group having a predetermined resistance interval between adjacent resistors which is larger than the small resistance interval.

These and other objects and features of this invention will become understood from the following description with reference to the accompanying drawings.
Fig. 1 is a diagram showing an electronic volume controller according to the present invention;
Fig. 2 is a circuit showing a part of the circuit shown in Fig. 1;
Fig. 3 is a diagram showing signals for data of the volume controller;
Fig. 4 is a diagram showing the allocation of the data allocated in the signal shown in Fig. 3:
Fig. 5 is a table showing bit allocation of main volume;
Fig. 6 is a table showing bit allocation of interpolation volume;
Fig. 7 is a graph showing attenuating characteristics in steps 0 to 11 of the electronic volume controller of the present invention;
Fig. 8 is a graph showing attenuating characteristics in steps 21 to 31 of the electronic volume controller;
Fig. 9 is a graph showing attenuating characteristics in steps 0 to 31 of the electronic volume controller; and
Fig. 10 is a diagram showing a conventional electronic volume controller.

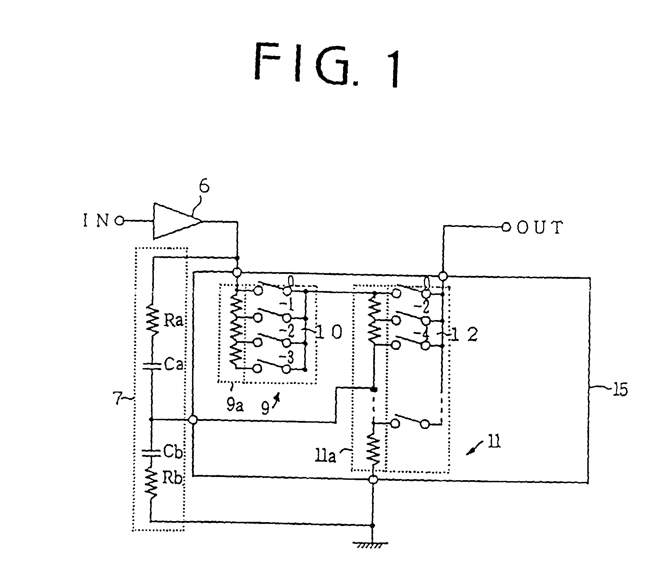

Referring to Fig. 1, an electronic volume controller 15 of the present invention being fabricated as an integrated circuit is shown. The same numerals as those in Fig. 10 designate the same parts in Fig. 1.

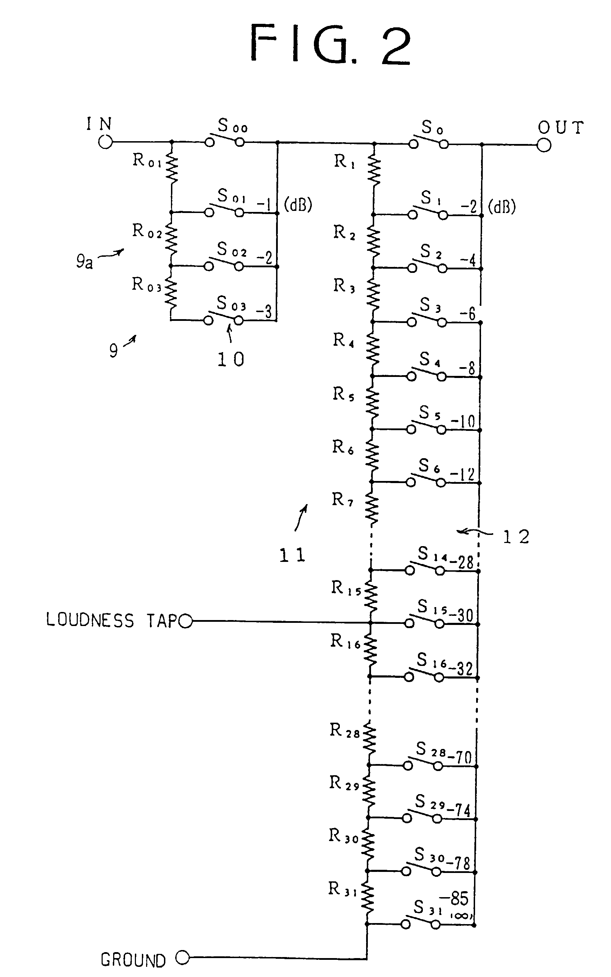

An input terminal of the volume controller 15 is connected to an auxiliary ladder attenuator 9 comprising a series of resistors 9a and a set of switches 10. As shown Fig. 2, the series of resistors 9a comprises resistors R01 to R03 and the set of switches 10 comprises analog switches S00 to S03 for attenuating the input signal from 0dB to 3dB by 1dB per step in accordance with the closing of one of the switches S00 to S03.

The ladder attenuator 9 is connected in series to a main ladder attenuator 11 comprising a series of resistors 11a and a set of switches 12. As shown in Fig. 2, the resistors 11a comprises resistors R1 to R31 and the switches 12 comprise analog switches S0 to S31. The resistors R1 to R22 are adapted to attenuate the input signal from 0dB to 42dB by 2dB per step and the resistors R23 to R31 are adapted to attenuate the signal from 42dB to ∞dB by 4dB per step.

The loudness circuit 7 comprising the resistors Ra and Rb and capacitors Ca and Cb is connected between the input of the auxiliary ladder attenuator 9 and the ground as shown in Fig. 1. A loudness tap of the loudness circuit 7 is connected to a point corresponding to -30dB between the resistors R15 and R16 of the main ladder attenuator 11.

The main ladder attenuator 11 is provided for providing a main volume adjustment, and the auxiliary ladder attenuator 9 is provided for interpolating the main volume.

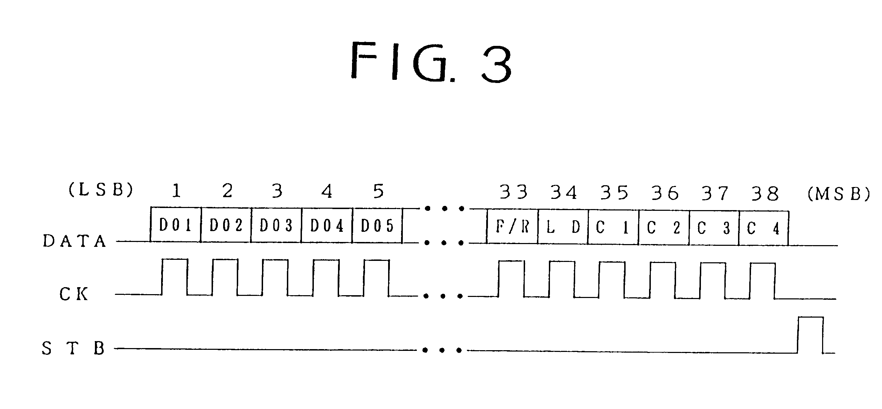

The analog switches S00 to S03 and S0 to S31 of the ladder attenuators 9 and 11 are operated by signals from a control unit (not shown) in dependency on data for controlling the volume. The data are provided by thirty eight bits and serially transferred through a data terminal (DATA), controlled by signals from clock terminal (CK) and strobe terminal (STB) as shown in Fig. 3.

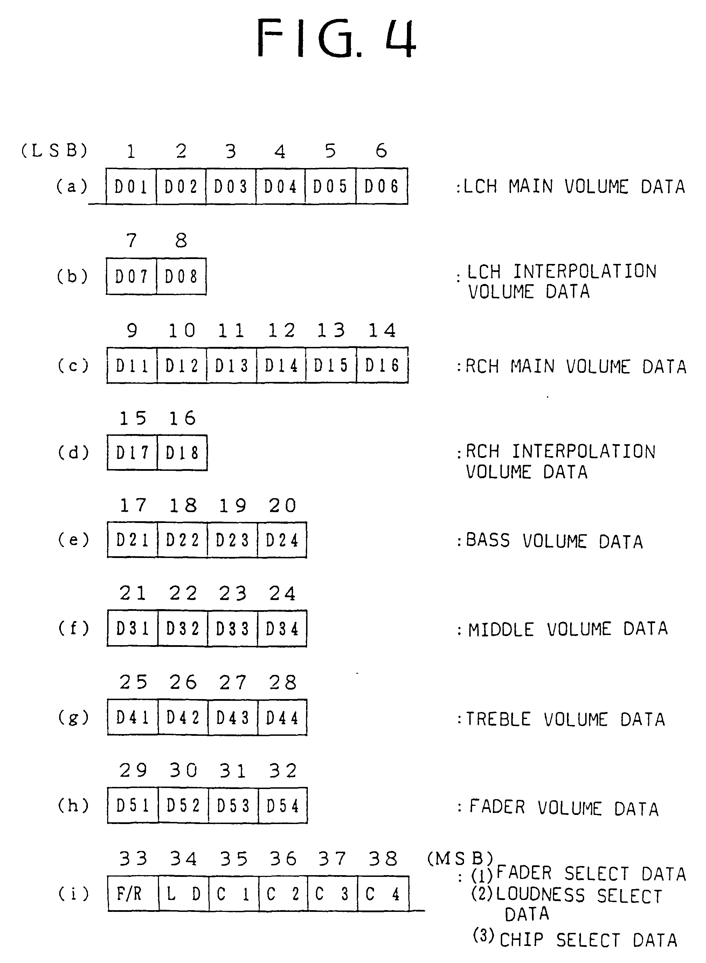

The data are allocated as shown in Figs. 4a to 4i. Lch (left channel) main volume data and Lch interpolation volume data are allocated in bits 1 to 6, and bits 7 and 8, respectively (Figs. 4a and 4b). Rch (right channel) main volume data and Rch interpolation volume data are allocated in bits 9 to 14 and bits 15 and 16, respectively (Figs. 4c and 4d). Bass volume data and middle volume data are allocated in bits 17 to 20 and bits 21 to 24, respectively (Figs. 4e and 4f). Bits 33 to 38 are provided for fader select data, loudness select data and IC chip select data (Fig. 4i).

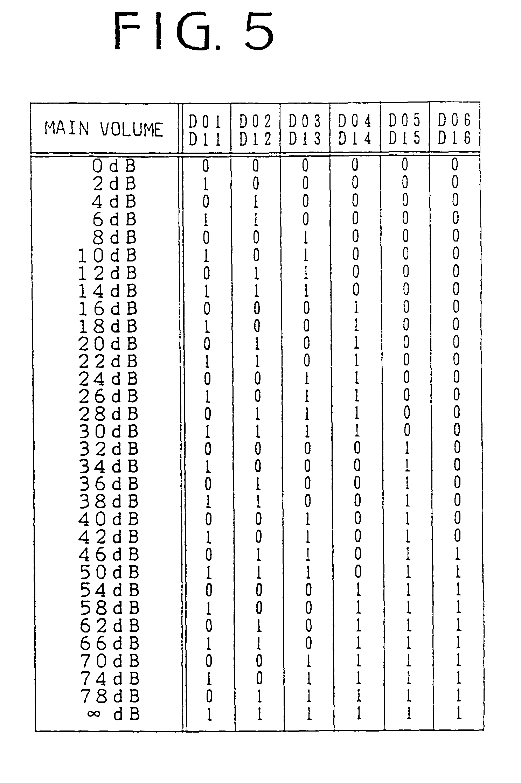

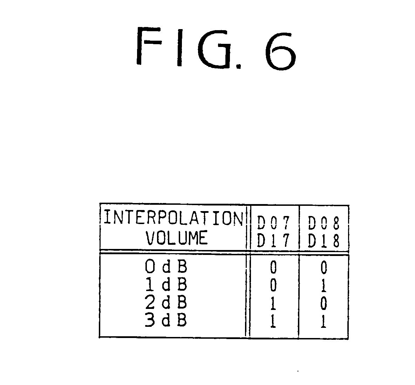

Figs. 5 and 6 show bit allocations for main volume and interpolation volume respectively.

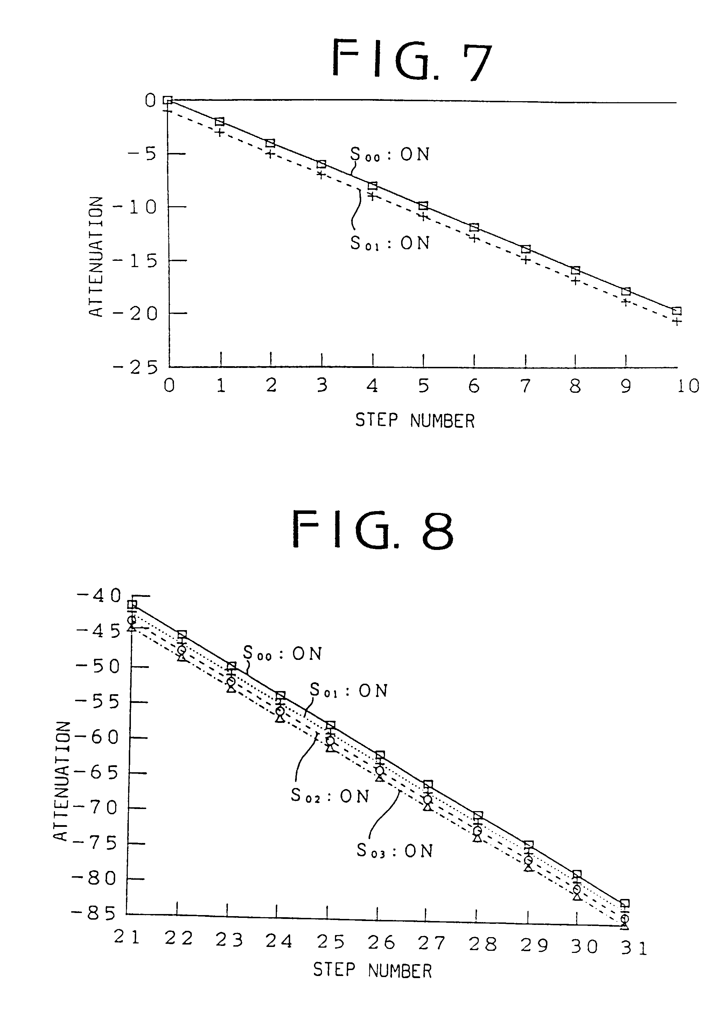

The operation of the present invention is described hereinafter with reference to Figs. 7 to 9.

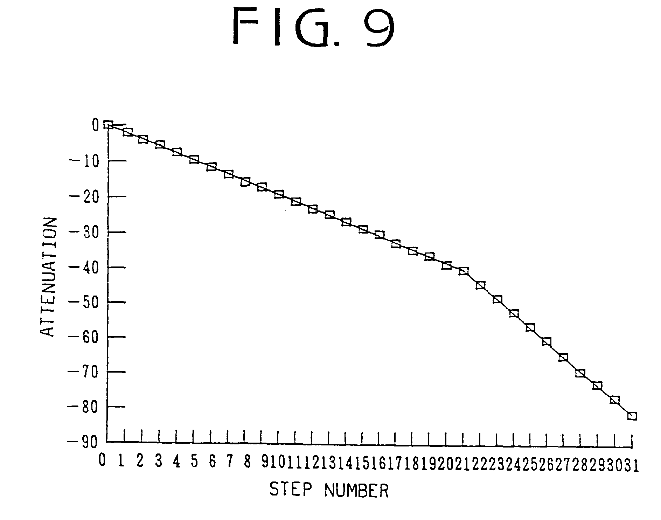

In order to attenuated the input signal, necessary analog switches selected from switch S1 to switch S31 of the switch set 12 are closed. If selected volume obtained by the selected switches is smaller than the necessary volume, necessary analog switches S00 to S03 of the interpolation volume ladder attenuator 9 are closed. Hence the input signal is gradually attenuated through steps 0 to 31 as shown in Fig. 9.

Fig. 7 shows the attenuating characteristics through the steps 0 to 10 when the analog switch S00 is closed, when the switch S01 is selectively closed, and switches S1 to S10 are serially and additionally closed. Fig. 8 shows the attenuating characteristics through the steps 21 to 31 when the switches S01 to S03 of the ladder attenuator 9 is selectively closed, and when switches S21 to S31 are additionally closed. Thus the input signal can be gradually attenuated 1dB to 85dB.

For example, in order to obtain the attenuation of -31dB, the analog switch S01 corresponding to -1bB of the auxiliary ladder attenuator 9 is closed. The main ladder attenuator 11 is operated so as to serially and additionally close the switch S1 to the switch S15 which corresponds to -30dB. Thus the input signal is gradually attenuated.

In accordance with the present invention, the attenuation at each step of the main ladder attenuator for the main volume is small, so that the input signal is gradually attenuated. Since the main ladder attenuator and the auxiliary ladder attenuator are connected in series and the attenuation of each step of the attenuators is small, the attenuators do not interfere with each other. Accordingly, a buffer amplifier is not needed between both the ladder attenuators.

While the presently preferred embodiment of the present invention has been shown and described, it is to be understood that this disclosure is for the purpose of illustration and that various changes and modifications may be made without departing from the scope of the invention as set forth in the appended claim.

## Claims

1. An electronic volume controller including a loudness circuit (7) having a loudness tap, said controller comprising:
a main ladder attenuator (11) having a plurality of resistors (11a) connected in series and a plurality of switches (12) each of which is provided for connecting a corresponding resistor (11a) to a main ladder attenuator output terminal;
an auxiliary ladder attenuator (9) having a plurality of resistors (9a) connected in series and a plurality of switches (10) each of which is provided for connecting a corresponding resistor (9a) to an auxiliary ladder attenuator output terminal;
the resistors (9a) of the auxiliary ladder attenuator (9) being provided for controlling volume by interpolation in smaller resistance steps between adjacent resistors (11a) of the main ladder attenuator (11);
characterized in that
the output terminal of said auxiliary ladder attenuator (9) is connected directly in series to an input terminal of the main ladder attenuator (11) without a buffer amplifier therebetween;
the resistors (11a) of the main ladder attenuator (11) are divided into a first group (R₁ - R₂₂) having a predetermined small resistance interval between adjacent resistors, and a second group (R₂₃ - R₃₁) having a predetermined resistance interval between adjacent resistors which is larger than said small resistance interval; and
the loudness circuit (7) is connected across the main ladder attenuator (11), wherein a loudness tap of the loudness circuit (7) is connected to an intermediate point within the first group (R₁ - R₂₂) of resistors (11a) of the main ladder attenuator (11).

## Patentansprüche

1. Elektronische Lautstärke-Regeleinrichtung, die eine Lautstärkeschaltung (7) mit einem Lautstärkeabgriff aufweist, wobei die Regeleinrichtung folgendes aufweist:
einen Hauptkettenspannungsteiler (11), der eine Vielzahl von in Reihe geschalteten Widerständen (11a) und eine Vielzahl von Schaltern (12) hat, die jeweils zum Verbinden eines entsprechenden Widerstands (11a) mit einem Ausgang des Hauptkettenspannungsteilers vorgesehen sind;
einen Hilfskettenspannungsteiler (9), der eine Vielzahl von in Reihe geschalteten Widerständen (9a) und eine Vielzahl von Schaltern (10) hat, die jeweils zum Verbinden eines entsprechenden Widerstands (9a) mit einem Ausgang des Hilfskettenspannungsteilers vorgesehen sind;
wobei die Widerstände (9a) des Hilfskettenspannungsteilers (9) vorgesehen sind, um die Lautstärke durch Interpolation in kleineren Widerstandsschritten zwischen benachbarten Widerständen (11a) des Hauptkettenspannungsteilers (11) zu regeln;
dadurch gekennzeichnet, daß
der Ausgang des Hilfskettenspannungsteilers (9) mit einem Eingang des Hauptkettenspannungsteilers (11) ohne einen Trennverstärker dazwischen direkt in Reihe geschaltet ist;
wobei die Widerstände (11a) des Hauptkettenspannungsteilers (11) in eine erste Gruppe (R₁ bis R₂₂), die ein vorbestimmtes kleines Widerstandswertintervall zwischen benachbarten Widerständen haben, und eine zweite Gruppe (R₂₃ bis R₃₁), die ein vorbestimmtes Widerstandswertintervall zwischen benachbarten Widerständen haben, das größer als das kleine Widerstandswertintervall ist, unterteilt sind; und
die Lautstärkeschaltung (7) zu dem Hauptkettenspannungsteiler (11) parallelgeschaltet ist, wobei ein Lautstärkeabgriff der Lautstärkeschaltung (7) mit einem Zwischenpunkt innerhalb der ersten Gruppe (R₁ bis R₂₂) von Widerständen (11a) des Hauptkettenspannungsteilers (11) verbunden ist.

## Revendications

1. Dispositif électronique de réglage de volume comprenant un circuit (7) d'intensité sonore ayant une prise de réglage d'intensité sonore, ledit dispositif de réglage comprenant :
un atténuateur en échelle (11) principal ayant plusieurs résistances (11a) branchées en série et plusieurs commutateurs (12), chacun d'eux étant prévu pour raccorder une résistance correspondante (11a) à une borne de sortie de l'atténuateur en échelle principal ;
un atténuateur en échelle (9) auxiliaire ayant plusieurs résistances (9a) branchées en série et plusieurs commutateurs (10), chacun d'eux étant prévu pour raccorder une résistance correspondante (9a) à une borne de sortie de l'atténuateur en échelle auxiliaire ;
les résistances (9a) de l'atténuateur en échelle (9) auxiliaire étant prévues pour régler le volume par interpolation dans des échelons de résistance plus petite entre des résistances adjacentes (11a) de l'atténuateur en échelle (11) principal ;
caractérisé en ce que
la borne de sortie dudit atténuateur en échelle (9) auxiliaire est branché directement en série à une borne d'entrée de l'atténuateur en échelle (11) principal, sans amplificateur tampon entre elles ;
les résistances (11a) de l'atténuateur en échelle (11) principal sont divisées en un premier groupe (R₁ - R₂₂) qui a un intervalle de résistance petit prédéterminé entre des résistances adjacentes, et un second groupe (R₂₃ R₃₁) qui a un intervalle de résistance prédéterminé entre des résistances adjacentes qui est plus grand que ledit intervalle de résistances petit ; et
le circuit (7) d'intensité sonore est relié aux bornes de l'atténuateur en échelle (11) principal, dans lequel une prise de réglage d'intensité sonore du circuit (7) d'intensité sonore est relié à un point intermédiaire, à l'intérieur du premier groupe (R₁ - R₂₂) de résistances (11a) de l'atténuateur en échelle (11) principal.
